# EUROPÄISCHE PATENTSCHRIFT

(11) **EP 3 242 232 B1**
(45) Veröffentlichungstag und Bekanntmachung des Hinweises auf die Patenterteilung: **27.02.2019**
(21) Anmeldenummer: 16168055.8
(22) Anmeldetag: 03.05.2016
(51) Int. Cl.: G06F 17/50

(54) **OPTIMIERTE ERZEUGUNG VON GESAMTNETZLISTE UND BITSTROM**
OPTIMISED PRODUCTION OF TOTAL NETWORK LIST AND BIT STREAM
PRODUCTION OPTIMISEE DE LISTE DE RESEAU TOTALE ET FLUX DE BITS

(43) Veröffentlichungstag der Anmeldung: 08.11.2017
(73) Patentinhaber: dSPACE digital signal processing and control engineering GmbH, 33102 Paderborn (DE)
(72) Erfinder: Bockelkamp, Matthias, 33106 Paderborn (DE)

(56) Entgegenhaltungen:
- EP-A1- 2 945 083
- EP-A2- 0 905 906
- WO-A1-01/41309
- US-A1- 2014 189 622
- US-B1- 8 407 645
- US-B2- 6 535 016

## Beschreibung

Die vorliegende Erfindung betrifft ein Verfahren zur Erzeugung einer Gesamtnetzliste sowie ein Verfahren zur Erzeugung eines Bitstroms aus der Gesamtnetzliste. Weiterhin betrifft die Erfindung eine programmierbare Datenverarbeitungseinrichtung zur Durchführung des obigen Verfahrens, ein Computerprogrammprodukt mit Computer-implementierten Anweisungen, das nach dem Laden und Ausführen in einer geeigneten Datenverarbeitungseinrichtung das obige Verfahren ausführt, sowie ein digitales Speichermedium mit elektronisch auslesbaren Steuersignalen, die so mit einer programmierbaren Datenverarbeitungseinrichtung zusammenwirken können, dass das obige Verfahren auf der Datenverarbeitungseinrichtung ausgeführt wird.

Die Echtzeitsimulation von komplexen, dynamischen Modellen stellt aufgrund der engen zeitlichen Randbedingungen selbst an moderne Rechenknoten hohe Anforderungen. Beispielsweise werden solche Modelle in automotiven Hardware-in-the-Loop-Simulationen (HIL) und im Bereich des automotiven Rapid Control Prototyping (RCP) eingesetzt, wo schnelle Regelkreise geschlossen werden müssen. Auch bei Regelstrecken, die eine hohe Dynamik aufweisen, wie zum Beispiel bei Elektromotoren, sind kurze Zykluszeiten und geringe Latenzen unabdingbar. Diese können allein mit CPU-basierten Simulationen, die auf einer CPU eines Rechenknotens (CN) laufen, praktisch kaum mehr umgesetzt werden. Der Begriff CN wird ausgehend von der CPU-basierten Verarbeitung in einem Rechenknoten auch generell für die CPU verwendet.

Eine programmierbare logische Schaltung, häufig auch in deutschsprachiger Fachliteratur als Programmable Logic Device oder kurz PLD bezeichnet, ist ein elektronisches Bauelement für integrierte Schaltkreise. Anders als logische Gatter, die eine feste Funktion vorgegeben haben, erhalten PLDs erst nach der Herstellung ihre Funktion durch die entsprechende Programmierung (Konfiguration). Einfache programmierbare logische Schaltungen bestehen meist aus einem Array aus UND-Verknüpfungen gefolgt von einem Array aus ODER-Verknüpfungen. Dazu gehören beispielsweise Programmable Read-Only Memory (PROM), Programmable Array Logic (PAL) bzw. Generic Array Logic (GAL), sowie programmierbare logische Anordnungen (PLA). Bei einem PLA sind sowohl das UND-Array als auch das ODER-Array programmierbar. Als programmierbare logische Schaltungen mit einer höheren Komplexität sind Complex Programmable Logic Device (CPLD) sowie Field Programmable Gate Array (FPGA) bekannt. CPLDs wie FPGAs bieten oft programmierbare I/O-Zellen, die es erlauben, verschiedene Signalschnittstellen anzuschließen.

Entsprechend können beispielsweise PLDs, insbesondere Field Programmable Gate Arrays (FPGAs), als zusätzliche Hardware-Komponenten bei der Echtzeitsimulation unterstützen, indem sie die Berechnung von dynamischen Teilen eines Modells übernehmen. Durch die hohe Flexibilität und Möglichkeit der Parallelverarbeitung von Signalen lassen sich durch den Einsatz von PLDs, insbesondere FPGAs, auch harte Echtzeitanforderungen leicht erfüllen. Die PLDs können allgemein als Hardwarebeschleuniger zur Unterstützung von CPUs dienen.

Für die Verwendung des PLDs, insbesondere FPGAs, gibt es zwei prinzipielle Möglichkeiten. In einer ersten Betriebsart (Manufacturer Mode) wird auf das PLD, insbesondere FPGA, eine fixe Funktionalität geladen, wodurch das PLD, insbesondere FPGA, konfiguriert wird. Diese fixe Funktionalität wird üblicherweise von einem Hersteller eines entsprechenden Systems bereitgestellt und im Weiteren als erster PLD-Code bezeichnet. Über diese fixe Funktionalität werden beispielsweise I/O-Kanäle mit einem festen Funktionsumfang bereitgestellt, so dass die I/O-Kanäle in einer Applikation in dem CN verwendet werden können. Von einer Applikation auf dem Prozessor des CN kann auf die fixe PLD Funktionalität und auf die I/O-Kanäle zugegriffen werden.

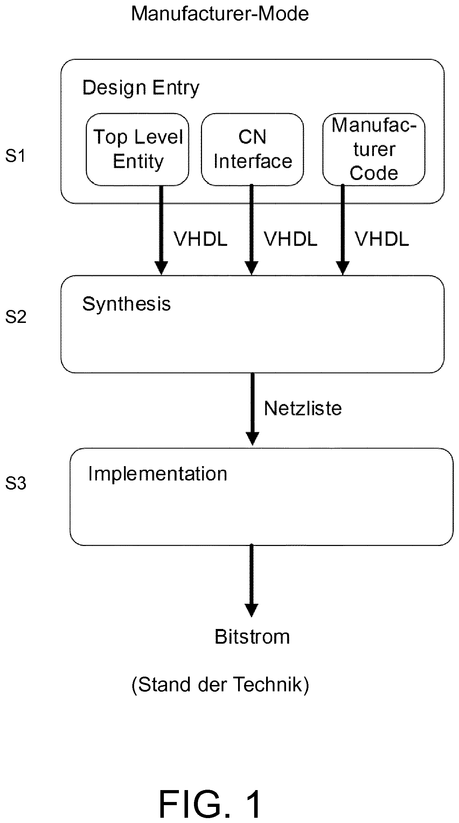

Ein Verfahren zur Erzeugung einer Gesamtnetzliste im Manufacturer Mode ist beispielsweise in Fig. 1 in vereinfachter Weise dargestellt. Dementsprechend wird in einem ersten Schritt S1, hier als "Design entry" bezeichnet, ein PLD-Code, hier als "Manufacturer Code" bezeichnet, erstellt, welcher bereitgestellte Funktionalität enthält. Zusätzlich wird eine Schnittstellenlogik zur Kommunikation mit dem CN bereitgestellt. Der PLD-Code und die Schnittstellenlogik können auch als ein Codeblock erstellt werden. Aus diesem PLD-Code wird in einem zweiten Schritt S2, hier als Synthese bezeichnet, eine Gesamtnetzliste erzeugt. Daraus wird in einem weiteren, dritten Schritt S3, der Implementierung, der die Schritte Platzieren und Routen umfasst, unter anderem ein Bitstrom zur Verwendung in dem FPGA erzeugt. Das gesamte Verfahren kann beispielsweise bei einem Systemhersteller durchgeführt werden, der Anwender erhält dann nur den Bitstrom zur Verwendung in dem FPGA.

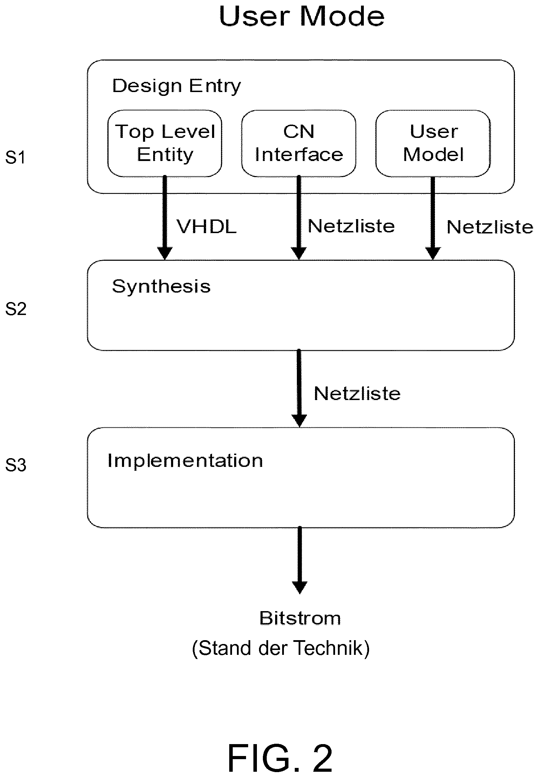

In einer zweiten Betriebsart (User Mode), die beispielsweise in Fig. 2 ebenfalls in vereinfachter Weise dargestellt ist, wird in einem ersten Schritt S1, hier wieder als "Design entry" bezeichnet, ein Modell erstellt, welches von dem Anwender bereitgestellte Funktionalität enthält. Dieser PLD-Code wird im Weiteren als zweiter FPGA-Code oder allgemein als zweiter PLD-Code bezeichnet. Aus diesem Modell wird in einem zweiten Schritt S2, hier als Synthese bezeichnet, unter Einbindung der Schnittstellenlogik eine Gesamtnetzliste erzeugt. Daraus wird in einem weiteren, dritten Schritt S3, der Implementierung, unter anderem ein Bitstrom zur Verwendung in dem FPGA erzeugt. Der so von dem Anwender modellbasiert erstellte zweite PLD-Code, der beispielsweise die I/O-Kanäle in dem FPGA verwendet, kann dann auf das FPGA geladen werden. Bei dem PLD-Code kann es sich beispielsweise um ein Regelmodell auf dem FPGA oder um eine Vorverarbeitung der I/O-Kanäle in dem FPGA handeln. Dieses Verfahren ist beispielsweise vorteilhaft, wenn die Schnittstellenlogik vom Gerätehersteller bereitgestellt wird. Dann muss der Anwender nur das Modell erstellen und das restliche Verfahren durchführen. Der Anwender muss sich hingegen nicht um die Anbindung der FPGA-Schnittstellen kümmern.

In diesem Zusammenhang ist beispielsweise aus der DE 10 2013 104 320 A1 ein besonders vorteilhaftes Verfahren zur Verbindung von nicht explizit verwendeten I/O-Kanälen bekannt.

Aus der US 2014 189 622 A1 ist ein Verfahren zur Programmierung eines PLDs bekannt, das die Aufteilung des Designs in zwei Teile für zwei Partitionen des PLDs vorsieht.

Aus der EP2945083A1 ist ein Verfahren zur Erstellung einer Netzliste aus zwei Komponenten bekannt.

Aus der EP0905906A2 ist eine Schaltung mit einem maskenprogrammierten Anteil und einem Feld-programmierbaren Anteil bekannt.

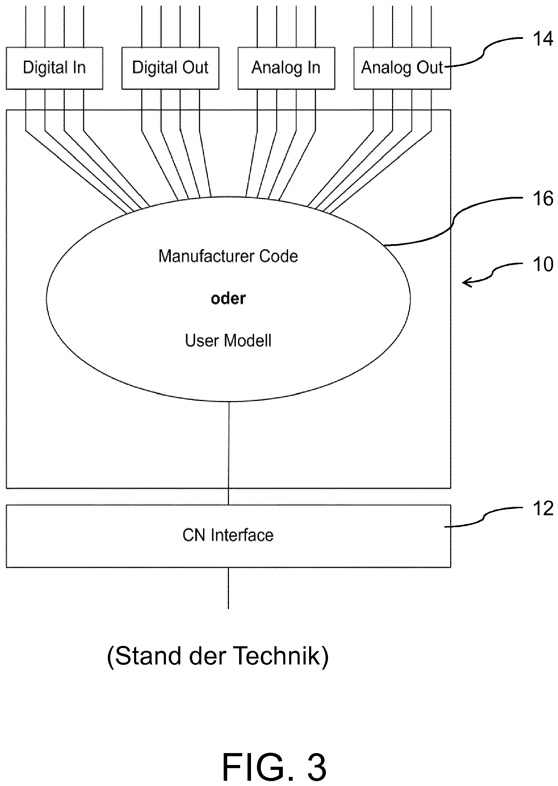

Eine weitere Darstellung der ersten beiden Verfahren ist in Fig. 3 gezeigt. Entsprechend ist auf einem FPGA 10 ein CN Interface 12 zu einem Rechenknoten bereitgestellt. Zusätzlich befindet sich auf dem FPGA in der ersten Betriebsart der Manufacturer Code 16 und in der zweiten Betriebsart das User Modell 16. Über das CN Interface 12 ist ein Datenaustausch zwischen dem Manufacturer Code 16 bzw. User Modell 16 und dem Rechenknoten möglich. Über IO-Kanäle 14 kann der FPGA Daten empfangen bzw. ausgeben. Empfange Daten können vom Manufacturer Code 16 bzw. User-Modell 16 verarbeitet und über das CN Interface 12 an den Rechenknoten weitergegeben werden.

Eine Kombination von Hersteller Code und Anwender Code durch das Einbinden von herstellerseitig vorsynthetisiertem Code, der typischerweise als Netzliste bereitgestellt wird, hat den Vorteil, dass dieser PLD-Code bereits "fertig" ist und sich leicht vom Anwender einbinden lässt. Nachteilig daran ist, dass der herstellerseitige Code dann immer den vollen Platz im FPGA belegt, um eine entsprechende Default-Funktionalität bereitzustellen. Entsprechend steht auf dem FPGA ein reduzierter Platz für PLD-Code des Anwenders bereit. Eine Verwendung eines größeren FPGA geht mit entsprechend höheren Kosten einher, und scheidet daher aus diesem Grund meist aus. Reserven für spätere Erweiterungen oder Bugfixes werden dadurch bereits am Anfang aufgebraucht. Weiterhin ist zu berücksichtigen, dass Kompilierzeiten bei hohem Füllstand des FPGA, d.h. bei zunehmender Belegung des FPGA, überproportional ansteigen, so dass eine entsprechende Ausnutzung des FPGA in der Praxis zu vermeiden ist. Dies gilt umso mehr bei Anwendungen im RCP-Umfeld, welche häufige Änderungen erfahren.

Eine an sich bekannte Methode, um nur den Teil des ersten PLD-Codes, der auch genutzt wird, einzubinden, besteht bspw. in der Nutzung von "generate"-Anweisungen. Diese funktionieren allerdings nicht mit vorsynthetisiertem Code, d.h. wenn der erste PLD-Code vom Hersteller typischerweise als Netzliste bereitgestellt wird. Das Bereitstellen des ersten Codes als erste Netzliste ist allerdings wichtig, um Buildzeiten für die Gesamtnetzliste aus dem ersten und zweiten PLD-Code gering zu halten. Abhängig von der Funktionalität sind Buildzeiten allein für den herstellerseitigen ersten PLD-Code von mehreren Stunden durchaus möglich. Somit muss eine Entscheidung gefällt werden, ob vorsynthetisierter Code, d.h. typischerweise die erste Netzliste, genutzt wird, um das Erstellen der Gesamtnetzliste zu verkürzen, oder ob der erste PLD-Code flexibel gekürzt werden kann, um mehr Kapazitäten für das Anwendermodell zur Verfügung zu haben, wobei sich die Buildzeiten entsprechend erheblich verlängern.

Ausgehend von dem oben genannten Stand der Technik liegt der Erfindung somit die Aufgabe zugrunde, ein Verfahren der oben genannten Art anzugeben, welches eine hohe Flexibilität bei der flexiblen, gleichzeitigen Verwendung von PLD-Code des Systemherstellers und eines Anwenders bei kurzen Buildzeiten ermöglicht. Eine weitere Aufgabe besteht in der Bereitstellung einer programmierbaren Datenverarbeitungseinrichtung, eines Computerprogrammprodukts mit Computer-implementierten Anweisungen sowie eines digitalen Speichermediums, um die genannten Aufgaben zu lösen.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Demnach erfolgt die Lösung der Aufgabe durch ein Verfahren zur Erzeugung einer Gesamtnetzliste mit den Schritten Bereitstellen eines ersten PLD-Codes als erste Netzliste, wobei der erste PLD-Code wenigstens einen ersten funktionalen Block aufweist, Bereitstellen eines zweiten PLD-Codes, wobei der zweite PLD-Code wenigstens einen zweiten funktionalen Block aufweist zur alternativen Verwendung anstelle eines entsprechenden ersten funktionalen Blocks, Bereitstellen eines Schalter-PLD-Codes mit wenigstens einem dem wenigstens einen ersten funktionalen Block zugeordneten Schalter zum Verbinden des dem Schalter zugeordneten ersten funktionalen Blocks, Verbinden des wenigstens einen zweiten funktionalen Blocks mit einem der wenigstens einen Schalter alternativ zu dem entsprechenden ersten funktionalen Block, Implementieren wenigstens eines Schalteransteuerungssignals für den wenigstens einen zweiten funktionalen Block, wobei das wenigstens eine Schalteransteuerungssignal dem entsprechenden Schalter zur Verbindung des wenigstens einen zweiten funktionalen Blocks zugeordnet ist, Erstellen der Gesamtnetzliste aus dem ersten PLD-Code, dem zweiten PLD-Code und dem Schalter-PLD-Code, und Entfernen funktionaler erster Blöcke, die basierend auf dem Schalteransteuerungssignal des entsprechenden Schalters nicht genutzt werden, aus der Gesamtnetzliste.

Erfindungsgemäß ist auch ein Verfahren zur Erzeugung eines Bitstroms angegeben, umfassend die Schritte Erzeugen einer Gesamtnetzliste gemäß dem obigen Verfahren, Erzeugen einer platzierten Netzliste aus der Gesamtnetzliste, Erzeugen einer gerouteten Netzliste aus der platzierten Netzliste, und Umwandeln der gerouteten Netzliste in einen Bitstrom.

Erfindungsgemäß ist außerdem eine programmierbare Datenverarbeitungseinrichtung zur Durchführung von einem oder beiden der obigen Verfahren angegeben.

Erfindungsgemäß ist weiter ein Computerprogrammprodukt mit Computer-implementierten Anweisungen angegeben, das nach dem Laden und Ausführen in einer geeigneten Datenverarbeitungseinrichtung eines oder beide der obigen Verfahren ausführt.

Erfindungsgemäß ist weiterhin ein digitales Speichermedium angegeben mit elektronisch auslesbaren Steuersignalen, die so mit einer programmierbaren Datenverarbeitungseinrichtung zusammenwirken können, dass eines oder beide der obigen Verfahren auf der Datenverarbeitungseinrichtung ausgeführt wird oder werden.

Grundidee der vorliegenden Erfindung ist es also, PLD-Code mit wenigstens einem Schalter bereitzustellen, um über den Schalter eine alternative Verwendung von ersten funktionalen Blöcken bzw. zweiten funktionalen Blöcken zu ermöglichen. Dies erfordert zwar das zusätzliche Bereitstellen der Schalter in dem Schalter-PLD-Code. Dieser zusätzliche Aufwand fällt allerdings nur vor der Erstellung der Gesamtnetzliste an. Ausgehend von der alternativen Verwendung der ersten und zweiten funktionalen Blöcke kann eine Optimierung der Gesamtnetzliste erfolgen. So können funktionale erste Blöcke, die basierend auf dem Schalteransteuerungssignal des entsprechenden Schalters nicht genutzt werden, entfernt werden, was in der Regel zu einer Erhöhung der Verfügbarkeit des PLD für PLD-Code des Anwenders, d.h. für den zweiten PLD-Code, führt. Somit können die Vorteile der Verwendung von herstellerspezifischem Code, der typischerweise als Netzliste bereitgestellt wird, mit den Vorteilen einer geringen Belegung von Ressourcen des PLD kombiniert werden, indem nur der Teil des ersten PLD-Codes, hier des PLD-Codes des Herstellers, auf das PLD geladen wird, der von dem Anwender wirklich genutzt werden kann. Somit können eigene Funktionen nach Bedarf implementiert werden, indem entsprechende zweite funktionale Blöcke in dem zweiten PLD-Code bereitgestellt werden. Trotzdem können Default-Funktionen in den ersten funktionalen Blöcken bereitgestellt werden, die von dem Anwender bei Bedarf einfach verwendet werden können.

Beispielsweise können die ersten und zweiten funktionalen Blöcke Code zur Ansteuerung einer Vorverarbeitungsstufe einer zugeordneten I/O-Ansteuerungsschnittstelle umfassen. Vorzugsweise weist dabei jeder der zweiten funktionalen Blöcke eine dem entsprechenden ersten funktionalen Block identische und somit geeignete Schnittstelle zur Ansteuerung der Vorverarbeitungsstufe der zugeordneten I/O-Ansteuerungsschnittstelle auf, um alternativ zu dem entsprechenden ersten funktionalen Block eine Ansteuerung der Vorverarbeitungsstufe der zugeordneten I/O-Ansteuerungsschnittstelle vornehmen zu können. Somit können in diesem Fall die Schalter über das Schalteransteuerungssignal entweder die Vorverarbeitungsstufe der zugeordneten I/O-Ansteuerungsschnittstelle mit dem zugeordneten ersten funktionalen Block oder mit dem zugeordneten zweiten funktionalen Block verbinden.

Der erste PLD-Code betrifft beispielsweise PLD-Code, der von einem Hersteller eines Systems zur Verwendung durch einen Anwender bereitgestellt wird. Hierbei handelt es sich beispielsweise um ein System zur Echtzeitsimulation von komplexen, dynamischen Modellen, das weiter beispielsweise in automotiven Hardware-in-the-Loop-Simulationen (HIL) oder im Bereich des automotiven Rapid Control Prototyping (RCP) eingesetzt wird, wo schnelle Regelkreise geschlossen werden müssen. Ein anderes Beispiel sind Regelstrecken, die eine hohe Dynamik aufweisen, wie zum Beispiel bei Elektromotoren, so dass kurze Zykluszeiten und geringe Latenzen unabdingbar sind.

Eine Netzliste kann in einem standardisierten Format (EDIF) zur Ablage einer Logik eines PLDs dargestellt werden. Sie ist üblicherweise das Ergebnis einer Synthese. Die Netzliste wird aus einem Quellcode synthetisiert, wobei der Quellcode, vorliegend z.B. als Text oder als grafisches Modell, unmittelbar bearbeitet werden kann, um Änderungen an der Logik des PLDs zu erreichen, die Netzliste aber üblicherweise nicht vom Verwender bearbeitet wird. Dies gilt prinzipiell für jede Netzliste. Beispiele für Netzlisten sind die weiter unten definierten erste und zweite Netzliste sowie die Gesamtnetzliste. Die Netzliste bezeichnet prinzipiell die Netzliste ohne weitere Informationen. Allerdings gibt es auch spezielle Varianten von Netzlisten als Zwischenschritte zur Erzeugung des Bitstroms, die zusätzliche Informationen beinhalten.

Aus der Netzliste kann in einem nachfolgenden Schritt, der auch als Platzierung (Place) bezeichnet wird, eine platzierte Netzliste erzeugt werden. Dabei werden die in der Netzliste beschriebenen Logikelemente konkreten Logikelementen des Ziel-FPGAs räumlich zugeordnet.

Die geroutete Netzliste ist das Ergebnis des Routings der platzierten Netzliste und enthält zusätzlich eine Festlegung von konkreten Verbindungsleitungen zwischen den konkreten Logikelementen des Ziel-PLDs.

Die geroutete Netzliste kann dann in einen Bitstrom umgewandelt werden, der auf das Ziel-PLD geladen werden kann.

Quellcode in Textform kann beispielsweise in einem HDL-Format wie Verilog, VHDL oder anderen Formaten bereitgestellt werden. Grafischer Quellcode, der auch als grafisches Modell bezeichnet wird, wird beispielsweise als Simulink-Modell, Ablaufdiagramm, Schaltplan oder in anderen Formen bereitgestellt.

Beim Erstellen der Gesamtnetzliste gibt es verschiedene Möglichkeiten, um den ersten PLD-Code, den zweiten PLD-Code und den Schalter-PLD-Code zusammenzuführen. So können die einzelnen PLD-Codes jeweils individuell zu einer Netzliste synthetisiert werden. Die so erzeugten Netzlisten werden dann unter einer darüber liegenden Top-Entity eingebunden. In einem weiteren Schritt werden die Netzlisten zusammengefügt und alle unbenutzten Funktionsblöcke wegoptimiert. Entsprechend können funktionale erste Blöcke, die basierend auf der Schalterinformation des entsprechenden Schalters nicht genutzt werden, entfernt werden.

Das Entfernen funktionaler erster Blöcke, die basierend auf dem Schalteransteuerungssignal des entsprechenden Schalters nicht genutzt werden, aus der Gesamtnetzliste, umfasst üblicherweise das Entfernen von logischen Elementen und Signalwegen.

Das Verfahren ist generell für beliebige programmierbare logische Schaltungen, auch Programmable Logic Device oder kurz PLD, anwendbar. PLDs sind elektronische Bauelemente für integrierte Schaltkreise, die erst nach der Herstellung ihre Funktion durch eine entsprechende Programmierung (Konfiguration) erhalten. PLDs umfassen Programmable Read-Only Memory (PROM), Programmable Array Logic (PAL) bzw. Generic Array Logic (GAL), programmierbare logische Anordnungen (PLA), Complex Programmable Logic Device (CPLD) sowie Field Programmable Gate Array (FPGA). Vorzugsweise betrifft das Verfahren die Programmierung eines FPGAs, so dass entsprechender erster bzw. zweiter PLD-Code bereitgestellt wird und eine entsprechende Gesamtnetzliste für ein FPGA aus dem PLD-Code erstellt wird. Erster und zweiter PLD-Code wie auch der Schalter-PLD-Code sind in diesem Fall erster und zweiter FPGA-Code wie auch Schalter-FPGA-Code.

In vorteilhafter Ausgestaltung der Erfindung umfasst das Verfahren den zusätzlichen Schritt des Voreinstellens des wenigstens einen Schalters in dem Schalter-PLD-Code zum Verbinden des zugeordneten ersten funktionalen Blocks. Durch das Voreinstellen des Schalters wird beispielsweise das Schalteransteuerungssignal mit einem Initialwert belegt, der durch jede Zuweisung überschrieben wird. Somit ist - bei der Verwendung des entsprechenden ersten funktionalen Blocks - keine zusätzliche Einstellung des entsprechenden Schalters erforderlich. Die Voreinstellung des Schalters bewirkt somit, dass der entsprechende erste funktionale Block voreingestellt ist, also nicht wegoptimiert wird. Ein falsch gesetzter Schalter würde sonst die Funktion wegoptimieren. Ein Schalter ohne gesetzte Schalterstellung würde evtl. zu einem Abbruch des Kompiliervorgangs führen.

In vorteilhafter Ausgestaltung der Erfindung umfasst der Schritt des Bereitstellens eines Schalter-PLD-Codes das Bereitstellen des Schalter-PLD-Codes als Teil des ersten PLD-Codes oder als separaten PLD-Code. Beispielsweise kann der Schalter-PLD-Code als separater PLD-Code beispielsweise als Quelltext oder als Teil des ersten PLD-Codes als Netzliste bereitgestellt werden. Besonders bevorzugt ist der Schalter-PLD-Code jedoch bereits in dem ersten PLD-Code enthalten, sodass er gemeinsam mit diesem als erste Netzliste bereitgestellt werden kann.

In einer weiteren besonders bevorzugten Ausgestaltung der Erfindung umfasst der Schritt des Implementierens wenigstens eines Schalteransteuerungssignals für den wenigstens einen zweiten funktionalen Block das Implementieren des wenigstens einen Schalteransteuerungssignals in dem zweiten PLD-Code. Entsprechend kann eine Trennung der Bereitstellung des Schalters als solchem und der Einstellung des Schalters, nämlich des Schalteransteuerungssignals, erfolgen. Dadurch wird eine effektive Handhabung des PLD-Codes ermöglicht. Durch die Implementierung des Schalteransteuerungssignals in dem zweiten PLD-Code kann ein Anwender einfach eine Auswahl des zu verwendenden ersten oder zweiten funktionalen Blocks durchführen. Im Ergebnis werden Buildzeiten auf ein Minimum beschränkt, da der Schalter als Teil des ersten PLD-Codes mit diesem bereits vorab als Teil der ersten Netzliste bereitgestellt werden kann. Alternativ kann das Schalteransteuerungssignal für den wenigstens einen zweiten funktionalen Block in dem Schalter-PLD-Code implementiert werden, wenn dieser Schalter-PLD-Code nicht als Netzliste sondern im Quellcode vorliegt. In der ersten Netzliste könnte das Schalteransteuerungssignal nicht mehr wie gewünscht von dem Anwender verändert werden, um den entsprechenden ersten oder zweiten funktionalen Block auszuwählen. In jedem Fall ist frühestens zum Zeitpunkt des Erstellens der Gesamtnetzliste sowohl der Schalter als auch das Schalteransteuerungssignal innerhalb einer Entität vorhanden, so dass der Schalter nicht bereits vorab im Zuge einer Optimierung entfernt werden kann. Entsprechend kann der erste PLD-Code in jedem Fall vorsynthetisiert werden, ohne dass der Schalter-PLD-code im Zuge einer Optimierung entfernt wird.

In vorteilhafter Ausgestaltung der Erfindung umfasst der Schritt des Implementierens wenigstens eines Schalteransteuerungssignals für den wenigstens einen zweiten funktionalen Block das Implementieren eines konstanten Schalteransteuerungssignals. Durch das Implementieren des konstanten Schalteransteuerungssignals wird auf einfache Weise eine permanente Auswahl des entsprechenden funktionalen Block getroffen. Diese kann auch automatisch beim Erstellen der Netzliste erkannt werden, um davon ausgehend die alternative Verwendung des entsprechenden ersten oder zweiten funktionalen Blocks in der Gesamtnetzliste zu bewirken. Ein entsprechender, aufgrund der Schalterstellung nicht verwendbarer erster funktionaler Block kann so leicht automatisch beim Erstellen der Gesamtnetzliste erkannt und entfernt werden.

In vorteilhafter Ausgestaltung der Erfindung umfasst das Verfahren den Schritt des Verbindens von I/O-Kanälen mit dem ersten bzw. zweiten funktionalen Block. Die I/O-Kanäle stellen den Zugang zu dem FPGA dar, über den beispielsweise Meß- und Steuersignale zum oder vom FPGA übertragen werden können. Die Art der Verarbeitung ist in dem FPGA selber implementiert. Die ersten funktionalen Blöcke bieten dabei vorzugsweise eine Standardfunktionalität für die Verarbeitung der über die oder an die I/O-Kanäle bereitgestellten Signale, welche durch den Anwender mit den zweiten funktionalen Blöcken nach Bedarf ersetzt werden kann. Als Eingang bzw. Ausgang des FPGA können Signale in definierter Weise in beide Richtungen übertragen werden. Vorzugsweise wird jedem der I/O-Kanäle ein Schalter zugeordnet. Dadurch kann jeder I/O-Kanal entweder mit dem Hersteller-Code oder mit dem Anwender-Code verbunden werden. An jedem I/O-Kanal kann zusätzlich eine Vorverarbeitungsstufe, beispielsweise ein A/D-Wandler, ein D/A-Wandler, ein Verstärker oder ähnliches, angeordnet sein. Die Vorverarbeitungsstufe ist entsprechend vorzugsweise zwischen dem Schalter und dem jeweiligen I/O-Pin angeordnet.

In vorteilhafter Ausgestaltung der Erfindung umfasst der Schritt des Bereitstellens eines ersten PLD-Codes als Netzliste das Bereitstellen des ersten PLD-Codes als verschlüsselte Netzliste. Durch das Bereitstellen des ersten PLD-Codes als verschlüsselte Netzliste kann der erste PLD-Code gegen unerwünschte Einsichtnahme oder gar Extraktion geschützt werden. Dem ersten PLD-Code zugrunde liegende interne Informationen können so vor einem unerwünschten Zugriff Dritter geschützt werden. Die Verwendung einer verschlüsselten Netzliste zur Erzeugung der Gesamtnetzliste kann ohne Einschränkung erfolgen. Die Verschlüsselung schränkt eine Verwendung beispielsweise in einem Compiler zur Erzeugung der Gesamtnetzliste bzw. des Bitstroms nicht ein. Genauer ergibt sich eine Einschränkung nur insofern, dass zur Weiterverarbeitung der verschlüsselten Netzliste nur solche Compiler verwendet werden können, deren öffentliche Schlüssel im verwendeten Verschlüsselungsprogramm hinterlegt sind. Unter Verschlüsselung wird in diesem Zusammenhang auch Obfuskation verstanden.

In vorteilhafter Ausgestaltung der Erfindung umfasst der Schritt des Bereitstellens eines zweiten PLD-Codes das Bereitstellen des zweiten PLD-Codes als Quellcode. Der Quellcode ist zu verstehen als unverarbeitete Nutzereingabe als Unterscheidung zur Netzliste, die einen verarbeiteten Quellcode darstellt. Der Quellcode stellt eine Beschreibung der Funktionalität einer Logik einer Entität dar. Der Anwender kann somit alle angebotenen Möglichkeiten zur Definition der Logik nutzen.

In vorteilhafter Ausgestaltung der Erfindung umfasst der Schritt des Bereitstellens eines zweiten PLD-Codes als Quellcode das Bereitstellen des zweiten PLD-Codes in Textform oder als grafisches Programm. Die Art der Bereitstellung des Quellcode ist dadurch auf praktisch beliebige Weise möglich. Prinzipiell sind auch Kombinationen von Quellcode in Textform und als grafisches Programm möglich.

In vorteilhafter Ausgestaltung der Erfindung umfasst der Schritt des Bereitstellens eines zweiten PLD-Codes das Bereitstellen des zweiten PLD-Codes als zweite Netzliste. Die Bereitstellung der zweiten PLD-Codes kann somit erfolgen, ohne dass zunächst eine Erstellung der zweiten Netzliste aus dem zweiten PLD-Code erfolgen muss. Eine bestehende Netzliste kann somit nach Erstellung der Gesamtnetzliste beliebig wiederverwendet werden. Dies kann auch nur einen Teil des zweiten PLD-Codes betreffen, wenn dieser beispielsweise zum Teil als Netzliste und zum Teil als Quellcode bereitgestellt wird.

In vorteilhafter Ausgestaltung der Erfindung umfasst der Schritt des Erstellens der Gesamtnetzliste aus dem ersten PLD-Code, dem zweiten PLD-Code und dem Schalter-PLD-Code, das Erstellen einer zweiten Netzliste und einer Schalter-Netzliste sowie das Mergen der ersten Netzliste, der zweiten Netzliste und der Schalter-Netzliste. Entsprechend kann beim Erstellen der Gesamtnetzliste zunächst aus jedem der PLD-Codes zunächst je eine Netzliste, d.h. die erste Netzliste, die zweite Netzliste oder die Schalter-Netzliste, erzeugt werden, wobei die einzelnen Netzlisten durch das Mergen zu einer Gesamtnetzliste kombiniert werden. Vorzugsweise erfolgt dabei auch das Entfernen von funktionalen ersten Blöcken, die basierend auf dem Schalteransteuerungssignal des entsprechenden Schalters nicht genutzt werden. Wenn der Schalter-PLD-Code bereits Teil des ersten PLD-Codes ist, kann das Erstellen der Gesamtnetzliste auch nur das entsprechende Erstellen einer ersten bzw. zweiten Netzliste sowie das Mergen dieser beiden Netzlisten umfassen. Das Mergen der Netzlisten wird vorzugsweise während der Synthese der zweiten Netzliste durchgeführt. Alternativ wird das Mergen der Netzlisten nach der Synthese der zweiten Netzliste während der Implementierung durchgeführt.

Weitergehende Details zu der Erstellung einer Gesamtnetzliste, beispielsweise mit einem Compiler, sind dem Fachmann als solche bekannt. Der Vollständigkeit halber wird auf "Vivado Design Suite User Guide" herunterladbar unter xilinx.com verwiesen, in dem diese Kenntnisse dokumentiert sind.

Nachfolgend wird die Erfindung unter Bezugnahme auf die anliegende Zeichnung anhand bevorzugter Ausführungsformen näher erläutert.

Es zeigen
- Fig. 1: ein Ablaufdiagramm eines an sich bekannten Verfahrens zur Erzeugung einer Gesamtnetzliste und eines Bitstroms aus einem Hersteller-PLD-Code gemäß dem Stand der Technik in Übereinstimmung mit einer ersten Ausführungsform,
- Fig. 2: ein Ablaufdiagramm eines an sich bekannten Verfahrens zur Erzeugung einer Gesamtnetzliste und eines Bitstroms aus einem Anwender-PLD-Code gemäß dem Stand der Technik in Übereinstimmung mit einer zweiten Ausführungsform,
- Fig. 3: eine weitere Darstellung eines FPGA als PLD mit einer Logik basierend auf Hersteller PLD-Code oder Anwender PLD-Code in Übereinstimmung mit der ersten bzw. zweiten Ausführungsform,
- Fig. 4: ein detailliertes Flussdiagramm eines erfindungsgemäßen Verfahrens zur Erzeugung einer Gesamtnetzliste basierend auf einer Mischung aus Hersteller PLD-Code und Anwender PLD-Code gemäß einer vierten, bevorzugten Ausführungsform,
- Fig. 5: ein verallgemeinertes und vereinfachtes Ablaufdiagramm des Verfahrens der vierten Ausführungsform,
- Fig. 6: ein detailliertes Ablaufdiagramm des Verfahrens zur Erzeugung eines Bitstroms aus einem PLD-Code gemäß einer fünften Ausführungsform,
- Fig. 7: eine Darstellung einer Logik eines FPGA basierend auf einer Mischung aus Hersteller PLD-Code und Anwender PLD-Code in Übereinstimmung mit den Verfahren den vierten und fünften Ausführungsformen,
- Fig. 8: die Darstellung einer Logik eines FPGA basierend auf Fig. 8, wobei nicht genutzte Signalwege zur Verbindung von Schaltern mit ersten bzw. zweiten funktionalen Blöcken entfernt wurden in Übereinstimmung mit den Verfahren den vierten und fünften Ausführungsformen,
- Fig. 9: die Darstellung einer Logik eines FPGA basierend auf Fig. 9, wobei zusätzlich nicht genutzte funktionale erste Blöcke des ersten PLD-Codes sowie die Schalter des Schalter-PLD-Codes entfernt wurden in Übereinstimmung mit den Verfahren den vierten und fünften Ausführungsformen, und
- Fig. 10: eine Darstellung eines Rechenknotens mit FPGA und CPU Zur Ausführung einer Mischung aus Hersteller PLD-Code und Anwender PLD-Code auf dem FPGA in Übereinstimmung mit den vierten und fünften Ausführungsformen.

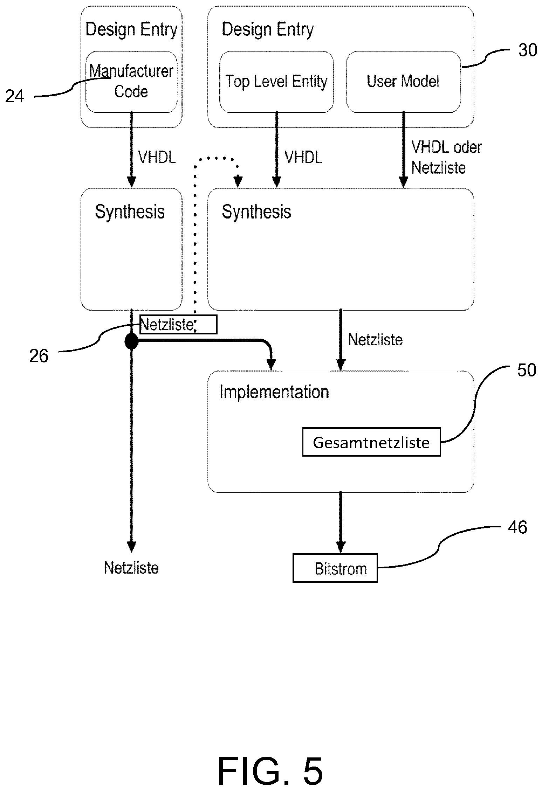

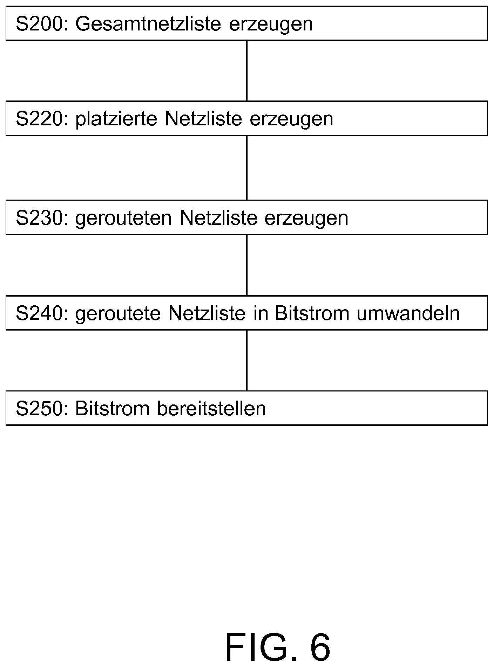

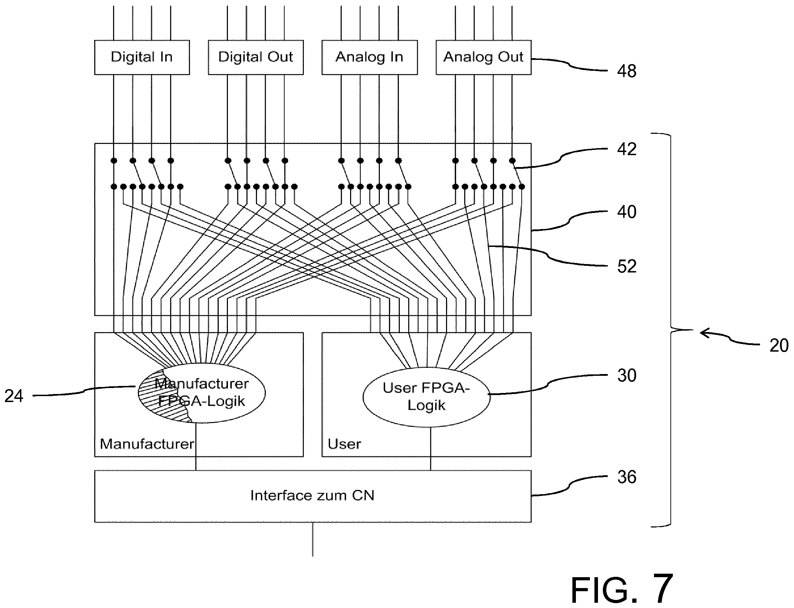

Die Figur 5 zeigt ein erfindungsgemäßes Verfahren zur Erzeugung einer Gesamtnetzliste 50 gemäß einer vierten, bevorzugten Ausführungsform, welches im Weiteren unter zusätzlichem Bezug auf die Figuren 6 und 8 bis 11 beschrieben wird. Eine Logik 20 eines FPGA 22 selber ist beispielsweise in den Figuren 7 bis 10 funktional dargestellt. Die Logik 20 stellt eine Logik dar, die das FPGA 22 nach einer Konfiguration repräsentiert.

In einem ersten Schritt S100 wird ein erster PLD-Code 24, der in diesem Ausführungsbeispiel für das FPGA 22 ein FPGA-Code ist, als erste Netzliste 26 bereitgestellt. Die erste Netzliste 26 ist in diesem Ausführungsbeispiel verschlüsselt. Die Netzliste kann in einem standardisierten Format (EDIF) vorliegen. Sie ist üblicherweise das Ergebnis einer Synthese und wird aus einem Quellcode erzeugt, wie in Fig. 5 dargestellt ist.

Der erste PLD-Code 24 ist in diesem Ausführungsbeispiel ein PLD-Code, der von einem Hersteller eines Systems zur Verwendung durch einen Anwender bereitgestellt wird. Hierbei handelt es sich in diesem Ausführungsbeispiel um ein System zur Echtzeitsimulation von komplexen, dynamischen Modellen, die beispielsweise in automotiven Hardware-in-the-Loop-Simulationen (HIL) und im Bereich des automotiven Rapid Control Prototyping (RCP) eingesetzt werden, wo schnelle Regelkreise geschlossen werden müssen. Ein anderes Beispiel sind Regelstrecken, die eine hohe Dynamik aufweisen und geringe Latenzen erfordern.

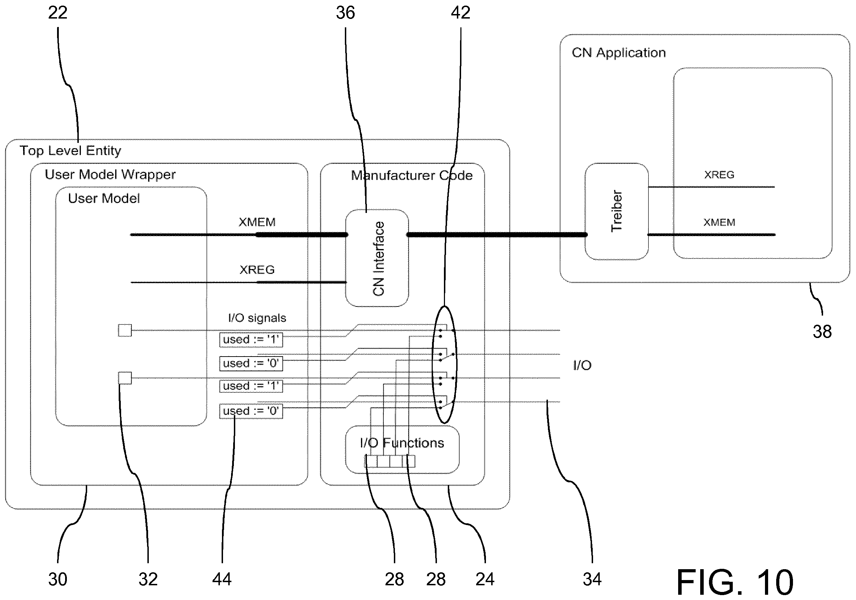

Der erste PLD-Code 24 weist eine Mehrzahl erster funktionaler Blöcke 28 auf, die beispielswese in Fig. 10 dargestellt sind.

In einem Schritt S110 wird ein zweiter PLD-Code 30 bereitgestellt. Der zweite PLD-Code 30 weist eine Mehrzahl zweiter funktionaler Blöcke 32 auf jeweils zur alternativen Verwendung anstelle eines entsprechenden ersten funktionalen Blocks 28. Die ersten bzw. zweiten funktionalen Blöcke 28, 32 werden mit dem CN Interface 36 verbunden. Das CN Interface 36 stellt den Zugang zu dem FPGA 22 dar zur Übertragung von Daten zwischen dem FPGA 22 und einem Modellteil 38, der auf einer CPU ausgeführt wird eines Rechenknotens. Die ersten funktionalen Blöcke 28 bieten hier eine Standardfunktionalität für die Verarbeitung von über die I/O-Kanäle 34 bereitgestellten Signalen. Die Standardfunktionalität der ersten funktionalen Blöcke 28 wird durch die zweiten funktionalen Blöcke 32 nach Bedarf ersetzt.

In einem Schritt S120 wird ein Schalter PLD-Code 40 bereitgestellt. Der Schalter-PLD-Code 40 umfasst eine Mehrzahl Schalter 42. Der Schalter-PLD-Code 40 ist in diesem Ausführungsbeispiel integral mit dem ersten PLD-Code 24 bereitgestellt.

In einem Schritt S130 wird jeder Schalter 42 mit einem entsprechenden ersten funktionalen Block 28 verbunden. Zusätzlich werden in Schritt S130 auch die zweiten funktionalen Blöcke 32 mit jeweils einem Schalter 40 verbunden. Die implementierten zweiten funktionalen Blöcke 32 stellen somit Alternativen zu dem entsprechenden ersten funktionalen Block 28 dar.

In einem Schritt S140 werden die Schalter 42 mit den I/O-Kanälen 34 des FPGA 22 verbunden. In diesem Ausführungsbeispiel ist jedem der I/O-Kanäle 34 ein Schalter 42 zugeordnet. Dies ist beispielhaft in Fig. 7 dargestellt. Wie dort erkennbar sind die Schalter 42 mit verschiedenen Ein- bzw. Ausgangssignalen 48 des FPGA 22 verbunden.

In einem Schritt S150 werden die Schalter 42 voreingestellt zur Verbindung mit den ersten funktionalen Blöcken 28.

In einem Schritt S160 werden Schalteransteuerungssignale 44 für die zweiten funktionalen Blöcke 32 implementiert. Die Schalteransteuerungssignale 44 sind in diesem Ausführungsbeispiel in dem zweiten PLD-Code 30 implementiert. Die Schalteransteuerungssignale 44 bewirken eine Einstellung der entsprechenden Schalter 42 zur Verbindung mit dem entsprechenden zweiten funktionalen Block 32. Die Schalteransteuerungssignale 44 sind in diesem Ausführungsbeispiel als konstante Signale implementiert, so dass mit der Belegung der Schalteransteuerungssignale 44 in dem Schalter-PLD-Code 40 eine permanente Auswahl für den entsprechenden ersten bzw. zweiten funktionalen Block 28, 32 getroffen ist.

In einem Schritt S170 wird die Gesamtnetzliste 50 aus dem ersten PLD-Code 24, dem zweiten PLD-Code 30 und dem Schalter-PLD-Code 40 erstellt. In diesem Ausführungsbeispiel wird der zweite PLD-Code 30 individuell zu einer zweiten Netzliste synthetisiert. Die erste Netzliste 26 und die zweite Netzliste des entsprechenden ersten und zweiten PLD-Codes 24, 30 werden dann unter einer Top-Entity eingebunden. Bei einem weiteren Schritt werden die erste Netzliste 26 und die zweite Netzliste zusammengefügt.

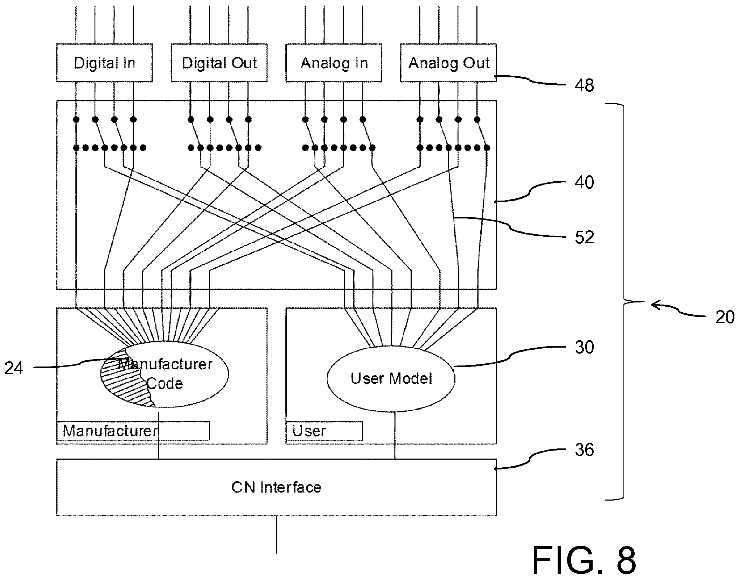

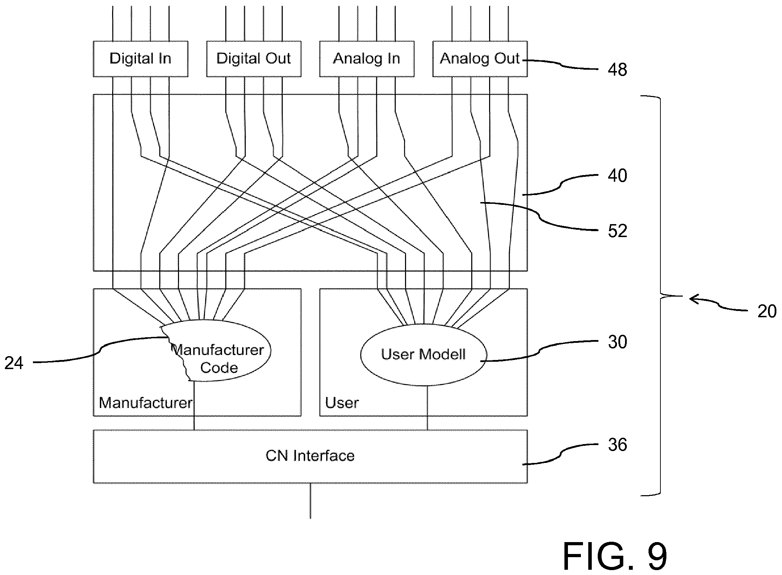

In einem Schritt S180 werden funktionale erste Blöcke 28, die basierend auf dem Schalteransteuerungssignal 44 des entsprechenden Schalters 42 nicht genutzt werden, aus der Gesamtnetzliste 50 entfernt. Dies ist in diesem Ausführungsbeispiel ebenfalls Teil des Erstellens der Gesamtnetzliste 50. Somit können alle unbenutzten ersten und zweiten funktionalen Blöcke 28, 32, üblicherweise erste funktionale Blöcke 28, die basierend auf dem Schalteransteuerungssignal 44 des entsprechenden Schalters 42 nicht genutzt werden, wegoptimiert werden. Dies schließt auch das Entfernen der Schalter 42 mit ein, wie unter Bezug auf die Figuren 7 bis 9 dargestellt ist. Entsprechend werden, wie in Fig. 8 gezeigt, Signalwege 52 zwischen den Schaltern 42 und den ersten bzw. zweiten funktionalen Blöcken 28, 32 entfernt. Darüber hinaus werden auch die Schalter 42 selbst entfernt, wie in Fig. 9 dargestellt ist. Schließlich ist in Fig. 9 erkennbar, dass nicht genutzte erste funktionale Blöcke 28 des ersten PLD-Codes 24 entfernt wurden.

In diesem Ausführungsbeispiel wird beim Erstellen der Gesamtnetzliste 50 automatisch erkannt, dass der Schalter 42 durch ein konstantes Schalteransteuerungssignal 44 gesetzt ist, so dass jeweils nur der entsprechende erste oder zweite funktionale Block 28, 32 verwendet werden kann.

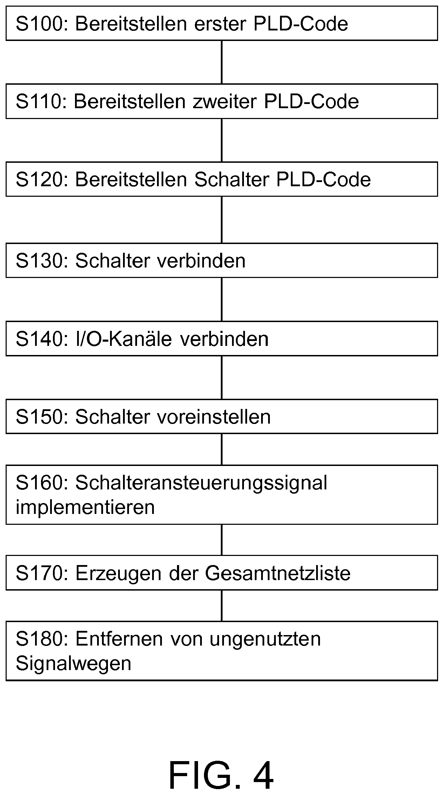

In Übereinstimmung mit dem unter Bezug auf Fig. 4 beschriebenen Verfahren ist in Fig. 5, welches das Verfahren stark vereinfacht darstellt, zusätzlich eine Verbindung von Codebestandteilen des FPGA 22 zu erkennen. Wie dargestellt wird von dem ersten PLD-Code 24 eine erste Netzliste 26 erstellt. Die erste Netzliste 26 wird von einem Hersteller erstellt und bereitgestellt und kann von einem Anwender verwendet werden. Der Anwender erzeugt den zweiten PLD-Code 30 als Quellcode. Der Quellcode stellt eine Beschreibung eines Teils Funktionalität der Logik 20 des FPGA 22 dar. In diesem Ausführungsbeispiel wird der Quellcode in Textform in dem Format VHDL bereitgestellt. In einer alternativen Ausführungsform wir der Quellcode in dem Format Verilog oder anderen Formaten bereitgestellt. In einer weiter alternativen Ausführungsform wird der Quellcode als grafischer Quellcode, der auch als grafisches Modell bezeichnet wird, bereitgestellt, beispielsweise als Simulink-Modell, Ablaufdiagramm, Schaltplan oder anderes.

Alternativ kann der zweite PLD-Code 30 als zweite Netzliste bereitgestellt werden, beispielsweise wenn bereits vorab ein Quellcode zu der zweiten Netzliste synthetisiert wurde und nun erneut verwendet werden soll, beispielsweise mit einem modifizierten ersten PLD-Code 24.

Das Zusammenfügen der ersten Netzliste mit dem zweiten PLD-Code kann bei der Synthese oder der Implementierung erfolgen. Dazu werden die erste Netzliste und der zweite PLD-Code in einer Top-Level-Entity instanziiert.

Unter Bezug auf Fig. 6 wird ein Verfahren zur Erzeugung eines Bitstroms 46 als Fortsetzung des obigen Verfahrens zur Erzeugung einer Gesamtnetzliste 50 gemäß einer fünften Ausführungsform der vorliegenden Erfindung beschrieben.

Entsprechend beginnt das Verfahren mit Schritt S200, der das oben unter Bezug auf die Schritte S100 bis S180 beschriebene Verfahren zum Erstellen einer Gesamtnetzliste 50 umfasst.

In einem Schritt S220 wird aus der in Schritt S200 erzeugten Gesamtnetzliste 50 einen platzierte Netzliste erzeugt. Dieser Schritt wird entsprechend auch als Placing bezeichnet. In der platzierten Netzliste sind den Logikelementen spezielle Logikelemente eines Ziel-FPGAs 22 zugeordnet.

In einem Schritt S230 wird dann aus der platzierten Netzliste eine geroutete Netzliste erzeugt. Die geroutete Netzliste ist Ergebnis des Routings der platzierten Netzliste und enthält eine Festlegung von Verbindungsleitungen zwischen einzelnen Logikelementen des FPGAs 22.

In Schritt S240 wird dann die geroutete Netzliste in einen Bitstrom 46 umgewandelt.

In Schritt S250 wird der Bitstrom 46 bereitgestellt. Der Bitstrom 46 kann dann nach Bedarf auf das FPGA 22 geladen werden.

**Bezugszeichenliste**

| | |
|---|---|
| FPGA (Stand der Technik) | 10 |
| Interface (Stand der Technik) | 12 |
| Ein- bzw. Ausgangssignale (Stand der Technik) | 14 |
| Erste bzw. zweite funktionale Blöcke (Stand der Technik) | 16 |
| Logik des FPGAs | 20 |
| FPGA | 22 |
| Erster PLD-Code | 24 |
| Netzliste | 26 |
| Erster funktionaler Block | 28 |
| Zweiter PLD-Code | 30 |
| Zweiter funktionaler Block | 32 |
| I/O-Kanal | 34 |
| Interface zum CN | 36 |
| Modellteil, der auf einer CPU ausgeführt wird | 38 |
| Schalter PLD-Code | 40 |
| Schalter | 42 |
| Schalteransteuerungssignal | 44 |
| Bitstrom | 46 |
| Ein- bzw. Ausgangssignal | 48 |
| Gesamtnetzliste | 50 |
| Signalweg | 52 |

## Patentansprüche

1. Computerimplementiertes Verfahren zur Erzeugung einer Gesamtnetzliste (50) mit den Schritten:
Bereitstellen eines ersten PLD-Codes (24) als erste Netzliste (26) wobei der erste PLD-Code (24) wenigstens einen ersten funktionalen Block (28) aufweist,
Bereitstellen eines zweiten PLD-Codes (30), wobei der zweite PLD-Code (30) wenigstens einen zweiten funktionalen Block (32) aufweist,
Bereitstellen eines Schalter-PLD-Codes (40) mit wenigstens einem dem wenigstens einen ersten funktionalen Block (28) zugeordneten Schalter (42) zum Verbinden des dem Schalter (42) zugeordneten ersten funktionalen Blocks (28),
Verbinden des wenigstens einen zweiten funktionalen Blocks (32) mit einem der wenigstens einen Schalter (42) alternativ zu dem entsprechenden ersten funktionalen Block (28),
Implementieren wenigstens eines Schalteransteuerungssignals (44) für den wenigstens einen zweiten funktionalen Block (32), wobei das wenigstens eine Schalteransteuerungssignal (44) dem entsprechenden Schalter (42) zur Verbindung des wenigstens einen zweiten funktionalen Blocks (32) zugeordnet ist,
Erstellen der Gesamtnetzliste (50) aus dem ersten PLD-Code (24), dem zweiten PLD-Code (30) und dem Schalter-PLD-Code (40),
**dadurch gekennzeichnet, dass**
der zweite funktionale Block (32) zur alternativen Verwendung anstelle des entsprechenden ersten funktionalen Blocks (28) vorgesehen ist,
der zweite funktionale Block (32) alternativ zu dem entsprechenden ersten funktionalen Block (28) mit einem der wenigstens einen Schalter (42) verbunden wird,
der Schritt des Implementierens wenigstens eines Schalteransteuerungssignals (44) für den wenigstens einen zweiten funktionalen Block (32) das Implementieren eines konstanten Schalteransteuerungssignals (44) umfasst,
Entfernen funktionaler erster Blöcke (28), die basierend auf dem Schalteransteuerungssignal (44) des entsprechenden Schalters (42) nicht genutzt werden, aus der Gesamtnetzliste (50), und
Entfernen des Schalters (42) selbst.

2. Computerimplementiertes Verfahren nach Anspruch 1, **dadurch gekennzeichnet, dass**
das Verfahren den zusätzlichen Schritt des Voreinstellens des wenigstens einen Schalters (42) in dem Schalter-PLD-Code (40) zum Verbinden des zugeordneten ersten funktionalen Blocks (28) umfasst.

3. Computerimplementiertes Verfahren nach einem der Ansprüche 1 oder 2, **dadurch gekennzeichnet, dass**
der Schritt des Bereitstellens eines Schalter-PLD-Codes (40) das Bereitstellen des Schalter-PLD-Codes (40) als Teil des ersten PLD-Codes (24) oder als separaten PLD-Code umfasst.

4. Computerimplementiertes Verfahren nach einem der vorhergehenden Ansprüche, **dadurch gekennzeichnet, dass**
der Schritt des Implementierens wenigstens eines Schalteransteuerungssignals (44) für den wenigstens einen zweiten funktionalen Block (28) das Implementieren des wenigstens einen Schalteransteuerungssignals (44) in dem zweiten PLD-Code (30) umfasst.

5. Computerimplementiertes Verfahren nach einem der vorhergehenden Ansprüche, **dadurch gekennzeichnet, dass**
das Verfahren den Schritt des Verbindens von I/O-Kanälen (34) mit dem ersten bzw. zweiten funktionalen Block (28, 32) umfasst.

6. Computerimplementiertes Verfahren nach einem der vorhergehenden Ansprüche, **dadurch gekennzeichnet, dass**
der Schritt des Bereitstellens eines ersten PLD-Codes (24) als erste Netzliste (26) das Bereitstellen des ersten PLD-Codes (24) als verschlüsselte Netzliste umfasst.

7. Computerimplementiertes Verfahren nach einem der vorhergehenden Ansprüche, **dadurch gekennzeichnet, dass**
der Schritt des Bereitstellens eines zweiten PLD-Codes (30) das Bereitstellen des zweiten PLD-Codes (30) als Quellcode umfasst.

8. Computerimplementiertes Verfahren nach dem der vorhergehenden Anspruch 7, **dadurch gekennzeichnet, dass**
der Schritt des Bereitstellens eines zweiten PLD-Codes (30) als Quellcode das Bereitstellen des zweiten PLD-Codes (30) in Textform oder als grafisches Programm umfasst.

9. Computerimplementiertes Verfahren nach einem der vorhergehenden Ansprüche, **dadurch gekennzeichnet, dass**
der Schritt des Bereitstellens eines zweiten PLD-Codes (30) das Bereitstellen des zweiten PLD-Codes (30) als zweite Netzliste umfasst.

10. Computerimplementiertes Verfahren nach einem der vorhergehenden Ansprüche, **dadurch gekennzeichnet, dass**
der Schritt des Erstellens der Gesamtnetzliste (50) aus dem ersten PLD-Code (24), dem zweiten PLD-Code (30) und dem Schalter-PLD-Code (40) das Erstellen einer zweiten Netzliste und einer Schalter-Netzliste sowie das Mergen der ersten Netzliste, der zweiten Netzliste und der Schalter-Netzliste umfasst.

11. Computerimplementiertes Verfahren zur Erzeugung eines Bitstroms (46), umfassend die Schritte:
Erzeugen einer Gesamtnetzliste (50) gemäß dem Verfahren nach einem der vorhergehenden Ansprüche 1 bis 10,
Erzeugen einer platzierten Netzliste aus der Gesamtnetzliste (50),
Erzeugen einer gerouteten Netzliste aus der platzierten Netzliste, und
Umwandeln der gerouteten Netzliste in einen Bitstrom (46) .

12. Programmierbare Datenverarbeitungseinrichtung zur Durchführung des Verfahrens nach einem der vorhergehenden Ansprüche.

13. Computerprogrammprodukt mit Computer-implementierten Anweisungen, das nach dem Laden und Ausführen in einer geeigneten Datenverarbeitungseinrichtung das Verfahren nach einem der vorhergehenden Ansprüche 1 bis 11 ausführt.

## Claims

1. A computer-implemented method for generating an overall netlist (50) having the steps:
providing a first PLD code (24) as a first netlist (26), the first PLD code (24) comprising at least one first functional block (28),
providing a second PLD code (30), the second PLD code (30) comprising at least one second functional block (32),
providing a switch PLD code (40) having at least one switches (42) associated with the at least one first functional block (28) for connecting the first functional block (28) associated with the switch (42),
connecting the at least one second functional block (32) to one of the at least one switches (42) as an alternative to the corresponding first functional block (28),
implementing at least one
switch activation signal (44) for the at least one second functional block (32), the at least one switch activation signal (44) being associated with the corresponding switch (42) for connecting the at least one second functional block (32),
creating the overall netlist (50) from the first PLD code (24), the second PLD code (30) and the switch PLD code (40),
**characterized in that**
the second functional block (32) is provided for alternative use instead of the corresponding first functional block (28),
the second functional block (32) is connected to one of the at least one switch (42) as an alternative to the corresponding first functional block (28),
the step of implementing at least one switch activation signal (44) for the at least one second functional block (32) comprises implementing a constant switch activation signal (44),
removing from the overall netlist (50) functional first blocks (28) that are not used based on the switch activation signal (44) of the corresponding switch (42), and
removing the switch (42) itself.

2. The computer-implemented method according to claim 1, **characterized in that**
the method comprises the additional step of presetting the at least one switch (42) in the switch PLD code (40) for connecting the associated first functional block (28).

3. The computer-implemented method according to one of claims 1 or 2, **characterized in that**
the step of providing a switch PLD code (40) comprises providing the switch PLD code (40) as part of the first PLD code (24) or as a separate PLD code.

4. The computer-implemented method according to one of the preceding claims, **characterized in that**
the step of implementing at least one switch activation signal (44) for the at least one second functional block (28) comprises implementing the at least one switch activation signal (44) in the second PLD code (30).

5. The computer-implemented method according to any one of the preceding claims, **characterized in that**
the method comprises the step of connecting I/O channels (34) to the first or second functional blocks (28, 32) .

6. The computer-implemented method according to one of the preceding claims, **characterized in that**
the step of providing a first PLD code (24) as the first netlist (26) comprises providing the first PLD code (24) as an encrypted netlist.

7. The computer-implemented method according to one of the preceding claims, **characterized in that**
the step of providing a second PLD code (30) comprises providing the second PLD code (30) as source code.

8. The computer-implemented method according to the preceding claim 7, **characterized in that**
the step of providing a second PLD code (30) as source code comprises providing the second PLD code (30) in text form or as a graphical program.

9. The computer-implemented method according to one of the preceding claims, **characterized in that**
the step of providing a second PLD code (30) comprises providing the second PLD code (30) as a second netlist.

10. The computer-implemented method according to one of the preceding claims, **characterized in that**
the step of creating the overall netlist (50) from the first PLD code (24), the second PLD code (30) and the switch PLD code (40) comprises creating a second netlist and a switch netlist and merging the first netlist, the second netlist and the switch netlist.

11. A computer-implemented method for generating a bitstream (46), comprising the steps of:
generating an overall netlist (50) according to the method according to one of the preceding claims 1 to 10,
generating a placed netlist from the overall netlist (50),
generating a routed netlist from the placed netlist, and
converting the routed netlist into a bitstream (46).

12. A programmable data processing device for carrying out the method according to one of the preceding claims.

13. A computer program product having computer-implemented instructions, which, after loading and execution in a suitable data processing device, executes the method according to one of the preceding claims 1 to 11.

## Revendications

1. Procédé mis en oeuvre sur ordinateur pour générer une liste de réseau globale (50), comprenant les étapes suivantes :
fournir un premier code PLD (24) en tant que première liste de réseau (26), sachant que le premier code PLD (24) présente au moins un premier bloc fonctionnel (28),
fournir un seconde code PLD (30), sachant que le second code PLD (30) présente au moins un second bloc fonctionnel (32),
fournir un code PLD de commutateur (40) ayant au moins un commutateur (42) attribué à l'au moins un premier bloc fonctionnel (28) pour connecter le premier bloc fonctionnel (28) attribué au commutateur (42),
connecter l'au moins un second bloc fonctionnel (32) avec l'un des au moins un commutateur (42) en alternative au premier bloc fonctionnel (28) correspondant,
mettre en oeuvre au moins un signal de commande (44) de commutateur pour l'au moins un second bloc fonctionnel (32), sachant que l'au moins un signal de commande de commutateur (44) est attribué au commutateur (42) correspondant pour connecter l'au moins un second bloc fonctionnel (32),
créer la liste de réseau globale (50) à partir du premier code PLD (24), du second code PLD (30) et du code de PLD de commutateur (40),
**caractérisé en ce que**
le second bloc fonctionnel (32) est prévu pour l'utilisation alternative à la place du premier bloc fonctionnel (28) correspondant,
le second bloc fonctionnel (32) est relié, en alternative au premier bloc fonctionnel (28) correspondant, avec l'un des au moins un commutateur (42),
l'étape consistant à mettre en oeuvre au moins un signal de commande (44) de commutateur pour l'au moins un second bloc fonctionnel (32) comprend la mise en oeuvre d'un signal de commande (44) de commutateur constant,
suppression, de la liste de réseau globale (50), des premiers blocs fonctionnels (28) qui ne sont pas utilisés sur la base du signal de commande (44) de commutateur du commutateur correspondant (42), et
suppression du commutateur (42) lui-même.

2. Procédé mis en oeuvre sur ordinateur selon la revendication 1, **caractérisé en ce que**
le procédé comprend l'étape supplémentaire consistant à prérégler l'au moins un commutateur (42) dans le code PLD de commutateur (40) pour connecter le premier bloc fonctionnel (28) associé.

3. Procédé mis en oeuvre sur ordinateur selon l'une des revendications 1 ou 2, **caractérisé en ce que**
l'étape consistant à fournir un code PLD de commutateur (40) comprend la fourniture du code PLD de commutateur (40) en tant que partie du premier code PLD (24) ou en tant que code PLD séparé.

4. Procédé mis en oeuvre sur ordinateur selon l'une des revendications précédentes, **caractérisé en ce que**
l'étape consistant à mettre en oeuvre au moins un signal de commande (44) de commutateur pour l'au moins un second bloc fonctionnel (28) comprend la mise en oeuvre de l'au moins un signal de commande (44) de commutateur dans le second code PLD (30) .

5. Procédé mis en oeuvre sur ordinateur selon l'une des revendications précédentes, **caractérisé en ce que**
le procédé comprenant l'étape consistant à connecter des canaux E/S (34) avec le premier ou le second bloc fonctionnel (28, 32), respectivement.

6. Procédé mis en oeuvre sur ordinateur selon l'une des revendications précédentes, **caractérisé en ce que**
l'étape consistant à fournir un premier code PLD (24) en tant que première liste de réseau (26) comprend la fourniture du premier code PLD (24) en tant que liste de réseau chiffrée.

7. Procédé mis en oeuvre sur ordinateur selon l'une des revendications précédentes, **caractérisé en ce que**
l'étape consistant à fournir un second code PLD (30) comprend la fourniture du second code PLD (30) en tant que code source.

8. Procédé mis en oeuvre sur ordinateur selon la revendication 7 précédente, **caractérisé en ce que**
l'étape consistant à fournir un second code PLD (30) en tant que code source comprend la fourniture du second code PLD (30) sous forme de texte ou en tant que programme graphique.

9. Procédé mis en oeuvre sur ordinateur selon l'une des revendications précédentes, **caractérisé en ce que**
l'étape consistant à fournir un second code PLD (30) comprend la fourniture du second code PLD (30) en tant que seconde liste de réseau.

10. Procédé mis en oeuvre sur ordinateur selon l'une des revendications précédentes, **caractérisé en ce que**
l'étape consistant à créer la liste de réseau globale (50) à partir du premier code PLD (24), du second code PLD (30) et du code PLD de commutateur (40) comprend la création d'une seconde liste de réseau et d'une liste de réseau de commutation, et le regroupement de la première liste de réseau, la seconde liste de réseau et la liste de réseau de commutation.

11. Procédé mis en oeuvre sur ordinateur pour générer un train de bits (46), comprenant les étapes suivantes :
créer une liste de réseau globale (50) selon le procédé selon l'une des revendications 1 à 10 précédentes,
créer une liste de réseau placée à partir de la liste de réseau globale (50),
créer une liste de réseau routée à partir de la liste de réseau placée, et
convertir la liste de réseau routée en train de bits (46).

12. Dispositif de traitement de données programmable pour l'exécution du procédé selon l'une des revendications précédentes.

13. Produit de programme informatique avec des instructions implémentées sur ordinateur, qui, après le chargement et le lancement dans un dispositif de traitement de données approprié, exécute le procédé selon l'une des revendications 1 à 11 précédentes.
